(19) Europäisches Patentamt
European Patent Office
Office européen des brevets

(11) **EP 3 355 097 A1**

(12) **EUROPÄISCHE PATENTANMELDUNG**

(43) Veröffentlichungstag:
**01.08.2018 Patentblatt 2018/31**

(51) Int Cl.:
*G02B 27/09* (2006.01)    *G02B 19/00* (2006.01)

(21) Anmeldenummer: **17153942.2**

(22) Anmeldetag: **31.01.2017**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**MA MD**

(71) Anmelder: **Fisba AG**
**9016 St. Gallen (CH)**

(72) Erfinder:
• **Moser, Hansruedi**
  **9452 Hinterforst (CH)**
• **Forrer, Hans**
  **9016 St. Gallen (CH)**
• **Forrer, Martin**
  **9050 Appenzell (CH)**
• **Huber, Michael**
  **9014 St. Gallen (CH)**

(74) Vertreter: **Hepp Wenger Ryffel AG**
**Friedtalweg 5**
**9500 Wil (CH)**

(54) **VORRICHTUNG ZUR KOLLIMATION EINES LICHTSTRAHLS, HOCHLEISTUNGSLASER UND FOKUSSIEROPTIK SOWIE VERFAHREN ZUM KOLLIMIEREN EINES LICHTSTRAHLES**

(57) Die vorliegende Erfindung richtet sich auf eine Vorrichtung (100) zur Kollimation eines Strahlungsfeldes einer Lichtquelle (L) mit einer Strahlcharakteristik die in einer ersten Ebene (F) unterschiedlich zu einer zweiten Ebene (S) ist. Die Vorrichtung umfasst mindestens eine erste Kollimationslinse (10) und eine zweite Kollimationslinse (20). Die Vorrichtung weist ein zusätzliches optisches Element (30) auf, um das Strahlungsfeld in einer zur ersten und zur zweiten Ebene unterschiedlichen Ebene zu kollimieren.

FIG 1

**Beschreibung**

Die vorliegende Erfindung betrifft eine Vorrichtung zur Kollimation eines Lichtstrahls, einen Hochleistungslaser und eine Fokussieroptik sowie ein Verfahren zum Kollimieren eines Lichtstrahles gemäss dem Oberbegriff der unabhängigen Ansprüche.

Vorrichtungen zum Kollimieren eines Lichtstrahles werden unter anderem in Hochleistungs-Diodenlasern und in Quantenkaskadenlasern eingesetzt. Typischerweise finden derartige Vorrichtungen Anwendung bei Lasern mit einem asymmetrischen Strahlfeld.

Ein Hochleistungs-Diodenlaser ist ein Halbleiterlaser mit einer Breitstreifenstruktur, um die Emission hoher Leistungen als Lichtstrahl im Wattbereich zu ermöglichen. Ein solcher Einzelemitter erzeugt einen Lichtstrahl aus einer Ursprungsebene mit einer relativ zu dieser vorgegeben Strahlrichtung. Entlang dieser Strahlrichtung erstrecken sich zwei Ebenen, eine erste Ebene (Fast-Axis) und eine dazu orthogonale Ebene (Slow-Axis). Der Strahl weist in der ersten Ebene eine andere Strahlcharakteristik auf als in der zweiten Ebene. Der Einzelemitter hat in der Ursprungsebene in der Fast Axis als Single Mode Emitter eine Dimension in der Grössenordnung von 1 micron und hat in dieser Ebene eine numerische Apertur von 0.5 - 0.7. In der Slow-Axis hat der Einzelemitter in der Ursprungsebene je nach Art bei Single Mode oder Multi Mode Emittern eine Dimension von 3 - 200 micron und der Lichtstrahl hat in dieser Ebene eine numerische Apertur von 0.05 - 0.2. Dies je nach Wellenlänge und Leistung der verwendeten Laserquelle.

Da diese Hochleistungs-Diodenlaser häufig in einen Lichtwellenleiter eingekoppelt werden, ist für eine Fokussierung ein möglichst symmetrisches Strahlungsfeld vor der Fokussieroptik anzustreben. Dabei ist es aus dem Stand der Technik bekannt, dies mit separater Kollimation in der Fast-Axis und Slow-Axis zu realisieren. Dabei wird zuerst die Fast-Axis mit einer zylindrischen Kollimationslinse FAC (Fast Axis Collimator) nur in dieser Ebene kollimiert. Danach werden in der Slow Axis Ebene mit einer zylindrischen Kollimationslinse SAC (Slow Axis Collimator) die Anteile der Lichtstrahlen in dieser Ebene kollimiert. Das Strahlungsfeld nach der FAC und SAC wird danach mit einer Fokussieroptik auf den Faserkern fokussiert.

Häufig werden zur Leistungssteigerung Laserdioden-Arrays mit mehreren Emittern auf einem Chip verwendet. Auch in diesem Fall wird eine FAC zur Kollimation eingesetzt. Da jedoch mehrere Emitter in der Ursprungsebene entlang der Slow Axis Ebene nebeneinander angeordnet sind, muss jeder Emitter mit einer separaten SAC kollimiert werden. Dies wird meist mit einem Array von nebeneinander liegenden SACs realisiert. Dabei muss der Abstand der SAC mit dem Abstand der Emitter übereinstimmen.

Weiter werden auch Chips mit mehreren Emittern in der Ursprungsebene, die entlang der Fast Axis Ebene nebeneinander angeordnet sind, verwendet. Auch in diesem Fall wird nur eine FAC zur Kollimation eingesetzt, da die Emitter in einem Abstand zwischen 5 und 20 micron liegen. Somit ist ein Laserdioden-Array in Slow und Fast Axis Ebene möglich.

Strahlung oder Anteile des Lichtes, die sich aber weder in der Fast Axis Ebene noch in der Slow Axis Ebene ausbreiten, werden nur ungenügend kollimiert. Es resultiert ein verwaschenes und zum Teil unscharfes Feld. Daraus kann sich, beispielsweise bei der Einkoppelung in einen Glasfaserleiter, ein Leistungsverlust ergeben, da nicht die vollständige Strahlung eingekoppelt werden kann, sondern im Wesentlichen nur der Teil, der vollständig kollimiert ist.

Typischerweise ist die numerische Apertur bei kurzwelligen Lichtstrahlen, beispielsweise von einer blauen Laserdiode mit einer Wellenlänge von ungefähr 450nm, grösser. Dadurch ergeben sich ebenfalls grössere Verluste.

Es ist Aufgabe der Erfindung diese und weitere Nachteile des Standes der Technik zu beheben.

Diese Aufgabe wird durch die in den unabhängigen Patentansprüchen definierten Vorrichtungen und Verfahren gelöst. Weitere Ausführungsformen ergeben sich aus den abhängigen Patentansprüchen.

Eine erfindungsgemässe Vorrichtung zur Kollimation eines Lichtstrahls mit einer Strahlcharakteristik, die in einer ersten Ebene unterschiedlich zu einer zweiten Ebene ist, umfasst wenigstens eine ersten Kollimationslinse zur Kollimation des Lichtstrahles in der ersten Ebene und eine zweite Kollimationslinse zur Kollimation des Lichtstrahls in der zweiten Ebene. Die Vorrichtung weist ein zusätzliches optisches Element auf, um den Lichtstrahl in zumindest einer zur ersten und zur zweiten Ebene unterschiedlichen Ebene und insbesondere allen zur ersten und zur zweiten Ebene unterschiedlichen Ebenen zu kollimieren.

Wie vorliegend dargelegt, weist der Lichtstrahl naturgemäss eine Fast Axis Ebene und eine Slow Axis Ebene auf. Zwischen diesen Ebenen weist das Strahlungsfeld einen Anteil an schiefen Ausbreitungsrichtungen auf, welche sich nicht nur in diesen Ebenen ausbreiten. Mit dem zusätzlichen optischen Element können diese Anteile des Lichtstrahls ebenfalls kollimiert werden. Dies ermöglicht eine vollständige Kollimation des Strahlungsfeldes und dadurch eine Leistungssteigerung, da ein im Vergleich zum Stand der Technik grösserer Anteil des Strahlungsfeldes kollimiert und daher gebündelt wird. Das heisst, dass ein grösserer Anteil des Strahlungsfeldes mit einer Fokussieroptik in einen bestimmten Bereich fokussiert werden kann.

Es ist vorstellbar, die erste und die zweite Kollimationslinse einteilig auszubilden, so dass die erste und die zweite Linse auch ans gleiche physische Element gebildet werden.

Das zusätzliche optische Element kann durch eine dritte Kollimationslinse gebildet sein.

Eine dritte Kollimationslinse ermöglicht es, diese mit einer Krümmung zu fertigen, die spezifisch auf die Anteile der schiefen Ausbreitungsrichtungen ausgelegt ist.

Dabei ist es möglich, die dritte Kollimationslinse in Strahlrichtung des Lichtstrahls nach der ersten und nach der zweiten Kollimationslinse anzuordnen.

Dies ermöglicht es, die Kollimation in drei Schritten durchzuführen, wobei in einem ersten Schritt die Kollimation in der Fast Axis durchgeführt wird, in einem zweiten Schritt die Kollimation in der Slow Axis und in einem dritten Schritt die Kollimation der schiefen Ausbreitungsrichtungen, das heisst der Anteile des Lichtes, welches auf keiner dieser beiden Ebenen liegt.

Die Anordnung der dritten Kollimationslinse, das heisst, des zusätzlichen optischen Elementes, am Schluss der Kollimationskette weist den Vorteil auf, dass ein grosser Teil des Strahlungsfeldes bereits in Fast Axis Ebene und Slow Axis Ebene kollimiert ist und mit dem zusätzlichen Element nur noch die Anteile der nicht in diesen Ebenen liegenden schiefen Ausbreitungsrichtungen fertig kollimiert werden müssen. Typischerweise wird der Anteil der schiefen Ausbreitungsrichtungen in diesen Ebenen bereits durch die erste und die zweite Kollimationslinse vorkollimiert. Dabei findet jedoch keine vollständige Kollimation statt. Mit dem zusätzlichen optischen Element wird nun dieser Anteil der Strahlungsfeldes fertig kollimiert, so dass danach das ganze Feld kollimiert ist.

Es ist jedoch ebenso vorstellbar, die dritte Kollimationslinse in Strahlrichtung zwischen der ersten und der zweiten Kollimationslinse anzuordnen.

Je nach den entsprechenden Anforderungen kann es vorteilhaft sein, die Anteile des Strahlungsfeldes, welche nicht auf den Hauptachsen liegen, zu kollimieren, bevor der Hauptanteil des Lichtes beispielsweise in der Slow Axis kollimiert wird. Dies ermöglicht es bereits vor einer abschliessenden Kollimation, die schiefen Ausbreitungsrichtungen des Lichtes ganz oder teilweise vorzukollimieren.

Vorzugsweise ist das zusätzliche optische Element jedoch durch einen Bereich auf der zweiten Kollimationslinse gebildet. Insbesondere bevorzugt ist das zusätzliche optische Element als integraler Bestandteil der zweiten Kollimationslinse ausgebildet.

Dies ermöglicht es, auf ein drittes, separates Element zu verzichten. Die Baugrösse der Vorrichtung kann damit klein gehalten werden. Da lediglich zwei Linsen ausgerichtet werden müssen, resultiert dies im Vergleich zu einer Vorrichtung mit einer dritten Kollimationslinse in einer Vorrichtung mit einer höheren Präzision. Eine Qualitätssteigerung ist somit möglich.

Kollimationslinsen weisen typischerweise in Strahlungsrichtung gesehen eine Eintrittsseite und eine Austrittsseite auf. Es kann vorgesehen sein, den Bereich für das zusätzliche optische Element auf der Eintrittsseite der zweiten Kollimationslinse anzuordnen und die Fläche zur Kollimation des Strahlungsfeldes in der zweiten Ebene auf der zweiten Kollimationslinse in Strahlungsrichtung austrittsseitig anzuordnen.

Dies ermöglicht es, ähnlich wie bei einer dritten Kollimationslinse, die zweite Fläche zur Kollimation des Strahlungsfeldes und das optische Element unabhängig von den anderen optischen Elementen, wie den anderen Kollimationslinsen, zu fertigen und entsprechend den Bedürfnissen auszugestalten.

Es ist jedoch auch vorstellbar, die Fläche zur Kollimation des Strahlungsfeldes in der zweiten Ebene mit dem zusätzlichen optischen Element zu kombinieren und auf der zweiten Kollimationslinse in Strahlungsrichtung austrittsseitig anzuordnen. Ebenfalls möglich und vorstellbar wäre es, diese Kombination in Strahlungsrichtung eintrittsseitig anzuordnen.

Die entsprechende Oberfläche der Linse ist dann als Freiformfläche ausgebildet. Das heisst, diese Fläche kann entsprechend der Charakteristik des eintretenden Lichtstrahls in unterschiedlichen Richtungen unterschiedlich gekrümmt sein, derart, dass zusätzlich zur Kollimation des Hauptanteiles des Lichtes in der Slow Axis ebenfalls der Anteil des Lichtes, welches weder auf der Slow noch auf der Fast Axis liegt, kollimiert wird.

Es ist ebenfalls vorstellbar, dass das zusätzliche optische Element durch einen Bereich auf der ersten Kollimationslinse gebildet ist und vorzugsweise als integraler Bestandteil der ersten Kollimationslinse ausgebildet ist.

Dabei kann es zusätzlich oder alternativ vorgesehen sein, den Bereich für das zusätzliche optische Element auf der Eintrittsseite der ersten Kollimationslinse anzuordnen und die Fläche zur Kollimation des Strahlungsfeldes in der ersten Ebene auf der ersten Kollimationslinse in Strahlungsrichtung austrittsseitig anzuordnen.

Dies ermöglicht es, ähnlich wie bei einer dritten Kollimationslinse, die erste Fläche zur Kollimation des Strahlungsfeldes und das optische Element unabhängig von den anderen optischen Elementen, wie den anderen Kollimationslinsen, zu fertigen und entsprechend den Bedürfnissen auszugestalten.

Es ist jedoch auch hier vorstellbar, die Fläche zur Kollimation des Strahlungsfeldes in der ersten Ebene mit dem zusätzlichen optischen Element zu kombinieren und auf der ersten Kollimationslinse in Strahlungsrichtung austrittsseitig anzuordnen. Ebenfalls möglich und vorstellbar wäre es, diese Kombination in Strahlungsrichtung auf der ersten Kollimationslinse eintrittsseitig anzuordnen.

Die entsprechende Oberfläche der Linse ist dann als Freiformfläche ausgebildet. Das heisst, diese Fläche könnte entsprechend der Charakteristik des eintretenden Lichtstrahls in unterschiedlichen Richtungen unterschiedlich gekrümmt sein, derart, dass zusätzlich zur Kollimation des Hauptanteiles des Lichtes in der Fast Axis ebenfalls der Anteil des Lichtes, welches weder auf der Slow noch auf der Fast Axis liegt, kollimiert wird.

Vorzugsweise ist das zusätzliche optische Element als Freiformfläche ausgebildet, wobei deren Oberfläche zumindest zwei unterschiedliche Krümmungen in zwei unterschiedlichen Richtungen aufweist und wobei zumindest eine der Krümmungen keinen konstanten Krümmungsradius aufweist.

Dies ermöglicht es, Lichtstrahlen mit unterschiedlichen Eintrittsrichtungen gleichermassen zu kollimieren und zu bündeln.

Vorzugsweise weist das zusätzliche optische Element eine Oberflächentopographie in der Form

$$H_{(x,y)} = a_{20}\,x^2 + a_{40}\,x^4 + a_{22}\,x^2 y^2 + \;+\; a_{60}\,x^6 + a_{42}\,x^4 y^2 + a_{24}\,x^2 y^4$$

wobei H die Höhe der Oberfläche in Ausbreitungsrichtung angibt und wobei x und y die orthogonalen Koordinatenachsen in der Ebene senkrecht zur Ausbreitungsrichtung sind und a spezifische Koeffizienten sind, in Abhängigkeit des Emitters.

Es ist ebenfalls denkbar, die erste Kollimationslinse und die zweite Kollimationslinse und das zusätzliche optische Element einstückig auszubilden. Dabei ist es vorteilhaft, wenn dieses einstückige Element eine optische Eintrittsfläche und eine optische Austrittsfläche aufweist, wobei diese gemäss der vorliegenden Beschreibung ausgebildet sein können. So kann beispielsweise die Eintrittsfläche das Strahlungsfeld in der Fast Axis Ebene und die schiefen Anteile des Strahlungsfeldes ganz oder teilweise kollimieren und die Austrittsfläche das Strahlungsfeld in der Slow Axis Ebene. Es ist ebenfalls vorstellbar, das Strahlungsfeld in der Slow Axis Ebene und die schiefen Anteile des Strahlungsfeldes gemeinsam ganz oder teilweise zu kollimieren.

Dies ermöglicht es, drei Kollimationen in Fast Axis Ebene, Slow Axis Ebene und allen Ebenen dazwischen in einem Element mit zwei optischen Flächen (Eintritts- und Austrittsfläche) zu vereinen. Dadurch kann die Präzision erhöht werden, bei gleichzeitig einfacherer Fertigung mit weniger Einzelteilen.

Ein weiterer Aspekt der Erfindung betrifft einen Hochleistungsdiodenlaser mit zumindest einem Emitter, bevorzugt mehreren Emittern und mindestens einer Vorrichtung wie vorliegend beschrieben.

Damit kann ein entsprechender Hochleistungsdiodenlaser mit einer ausgewählten Charakteristik bereitgestellt werden, welcher eine im Vergleich zum Stand der Technik höhere Effizienz durch eine verbesserte Kollimation der gesamten emittierten Strahlung aufweist.

Der vorgeschlagene Hochleistungsdiodenlaser kann ein Array aus mehreren Emittern, die in einer Ursprungsebene entlang der Fast Axis oder entlang der Slow Axis Ebene nebeneinander angeordnet sind, umfassen. Dabei ist insbesondere jedem Emitter ein zusätzliches optisches Element zugeordnet.

Ein Aspekt der Erfindung betrifft daher ein Array aus mehreren Kollimationslinsen, insbesondere für einen Hochleistungsdiodenlaser oder ein Modul wie vorliegend beschrieben. Dieses Kollimationslinsenarray umfasst zwei oder mehrere erste Kollimationslinsen zur Kollimation des Strahlungsfeldes in der ersten Ebene und/oder zwei oder mehrere zweite Kollimationslinsen zur Kollimation des Lichtstrahls in der zweiten Richtung. Das Kollimationslinsenarray weist je Kollimationslinse ein zusätzliches optisches Element auf, um die schiefen Ausbreitungsrichtungen des Strahlungsfeldes in einer zur ersten Ebene und zur zweiten Ebene unterschiedlichen Ebene zu kollimieren. Dabei ist das optische Element vorzugsweise jeweils als Freiformfläche an der entsprechenden Kollimationslinse gefertigt.

Die Kollimation in der ersten Ebene kann mit einer gemeinsamen Kollimationslinse für alle Emitter realisiert werden, da die Emitter in Slow Axis sehr genau nebeneinander liegen.

Dies ermöglicht das Bereitstellen eines Hochleistungsdiodenlasers mit einer hohen Leistung, wobei jeder einzelne Emitter individuell kollimierbar ist, was eine maximale Effizienz ermöglicht. Diese Anordnung ermöglicht eine höhere Leistungsdichte bei einer Fokussierung innerhalb eines vorgegebenen Bereichs, da die schiefen Ausbreitungsrichtungen des Strahlungsfeldes für jeden Emitter vollständig kollimiert werden.

Ein weiterer Aspekt der Erfindung betrifft ein Modul mit einer Vorrichtung oder einen Hochleistungsdiodenlaser wie vorliegend beschrieben und eine Fokussieroptik.

Dadurch ist es möglich, einen Lichtstrahl mit der vorliegend beschriebenen Charakteristik und den vorliegend beschriebenen Vorteilen bereitzustellen, so dass eine Einkoppelung in ein entsprechendes Element mit hoher Effizienz möglich ist.

Ein weiterer Aspekt der Erfindung betrifft ebenfalls ein Verfahren zum Kollimieren eines Lichtstrahles mit einer Strahlcharakteristik, die in einer ersten Ebene unterschiedlich zu einer zweiten Ebene ist. Vorzugsweise wird das Verfahren mit einer wie vorliegend beschriebenen Vorrichtung oder einem vorliegend beschriebenen Hochleistungsdiodenlaser oder einem wie vorliegend beschriebenen Modul durchgeführt. Das Verfahren umfasst die Schritte

- Kollimation der Anteile des Lichtstrahles der ersten Ebene
- Kollimation der Anteile des Lichtstrahles der zweiten Ebene
- Kollimation von Anteilen des Strahlungsfeldes, welche zur ersten Ebene und zur zweiten Ebene eine unterschiedliche Richtung aufweisen.

Dieses Verfahren ermöglicht es, einen höheren Anteil des Strahlungsfeldes zu kollimieren und für eine spätere Fokussieroptik zur Verfügung zu stellen. Die Leistungsdichte wird dadurch erhöht.

Vorzugsweise werden dabei zwei Kollimationen kombiniert durchgeführt, insbesondere die Kollimation der Anteile des Strahlungsfeldes der zweiten Ebene und die Kollimation von den Anteilen des Strahlungsfeldes, welche sowohl zur ersten Ebene als auch zur zweiten Ebene eine unterschiedliche Ebene aufweisen.

Anhand der folgenden Figuren wird die Erfindung erklärt. Es zeigen:

Figur 1:             Eine Vorrichtung gemäss dem Stand der Technik

Figur 1a:            Ein Detail der Vorrichtung gemäss der Figur 1

Figur 2:             Das Strahlungsfeld nach der Kollimation in der ersten und zweiten Ebene der Vorrichtung gemäss der Figur 1

Figur 3:             Ein erfindungsgemässes Ausführungsbeispiel der Vorrichtung

Figur 3a:            Ein Detail der Vorrichtung aus Figur 3

Figur 4:             Das Strahlungsfeld nach der Kollimation der Vorrichtung aus der Figur 3

Figuren 5a bis 6c:   Vergleichsversuche zu den Vorrichtungen aus den Figuren 1 und 3.

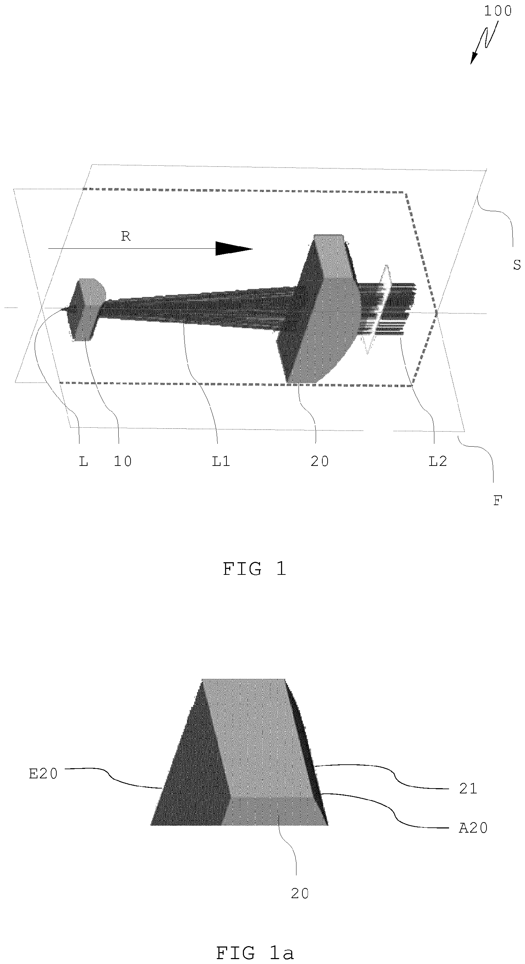

Die Figur 1 zeigt eine Vorrichtung zum Kollimieren eines Lichtstrahls gemäss dem Stand der Technik. Das Strahlungsfeld L einer Lichtquelle (eines Emitters) weist eine Ausbreitungsrichtung R auf und tritt nacheinander durch eine erste Kollimationslinse 10 und eine zweite Kollimationslinse 20.

Die Lichtquelle (Emitter) ist in vorliegender Figur nicht gezeigt. Der Emitter definiert eine Ursprungsebene, aus welcher sich das Strahlungsfeld L mit einer Strahlrichtung R erstreckt. Entlang dieser Strahlrichtung R erstrecken sich zwei Ebenen, eine erste Ebene F (Fast-Axis) und eine dazu orthogonalen Ebene S (Slow-Axis). Das Strahlungsfeld L weist in der ersten Ebene F eine andere Strahlcharakteristik auf als in der zweiten Ebene S.

Dabei wird der Anteil des Strahlungsfeldes in der ersten Kollimationslinse 10 in der Fast Axis Ebene F kollimiert. Das Strahlungsfeld L weist danach eine neue Charakteristik auf und ist als Strahlungsfeld L1 bezeichnet. Das Strahlungsfeld L1 tritt in die zweite Kollimationslinse 20 ein, welche das Licht in der Slow Axis Ebene S kollimiert. Das gerichtete (kollimierte) Strahlungsfeld L1 weist nach der zweiten Kollimationslinse 20 wiederum eine neue Charakteristik auf und ist als Strahlungsfeld L2 bezeichnet.

Die Figur 1a zeigt ein Detail der Kollimationslinse 20 aus der Figur 1 mit einer Eintrittsseite E20 und einer Austrittsseite A20. An der Austrittsseite A20 ist eine Fläche 21 zur Kollimation des Strahlungsfeldes in der zweiten Ebene angeordnet. Die Fläche 21 ist vorliegend zylindrisch ausgebildet.

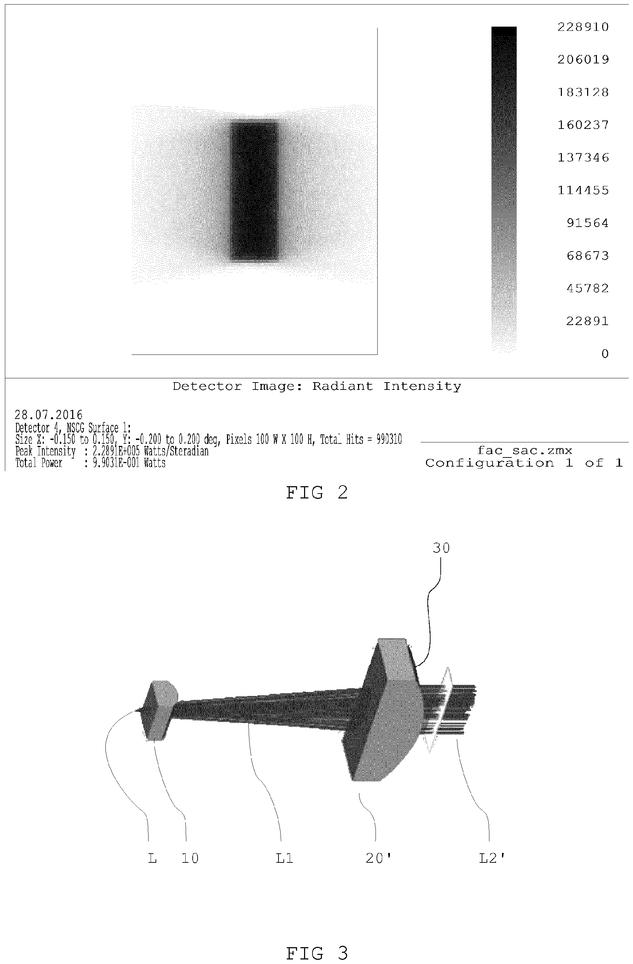

Die Figur 2 zeigt eine Simulation des Feldes nach einer FAC und SAC Kollimation mit einer Vorrichtung aus dem Stand der Technik gemäss Figur 1. Erkennbar sind die verwaschenen Bereiche am Rand des Feldes, welche aus den nicht kollimierten Anteilen des Strahlungsfeldes resultieren, welche auf keiner der beiden Ebenen liegen.

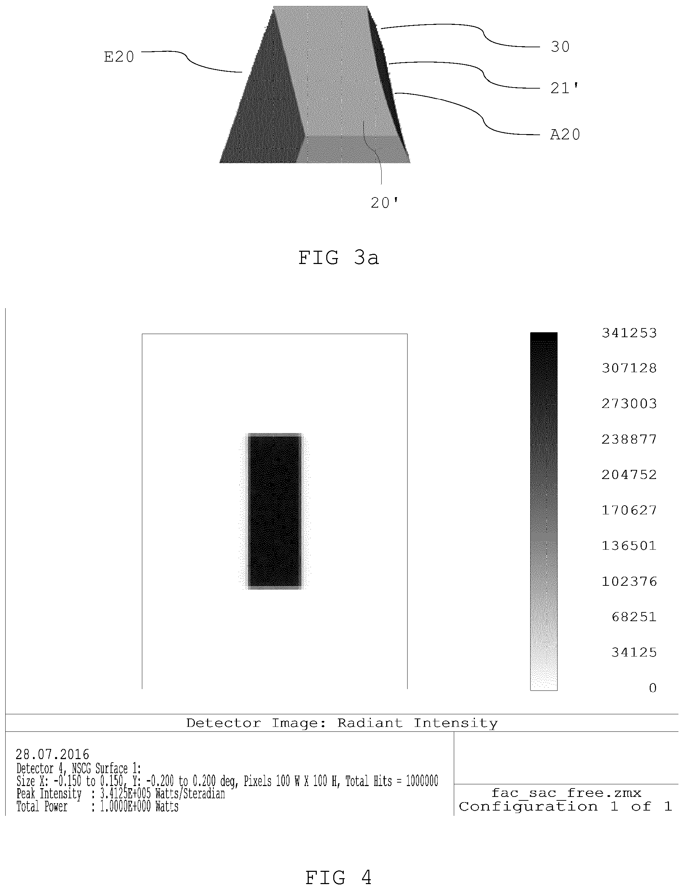

Figur 3 zeigt eine Ausführungsform der erfindungsgemässen Vorrichtung. Die Vorrichtung aus Figur 3 entspricht in ihrem Aufbau der Vorrichtung aus Figur 1 mit einer ersten Kollimationslinse 10 und einer Kollimationslinse 20'. Die zweite Kollimationslinse 20' ist vorliegend mit einem zusätzlichen optischen Element 30 ausgebildet. Das Strahlungsfeld einer Lichtquelle L tritt ebenfalls wie in Figur 1 zuerst durch die erste Kollimationslinse 10 und breitet sich danach als Strahlungsfeld L1 weiter durch die zweite Kollimationslinse 20' aus und verlässt die zweite Kollimationslinse 20' als Strahlungsfeld L2'.

Figur 3a zeigt das zu Figur 1 entsprechende Detail aus Figur 3, nämlich einen Teil der Linse der zweiten Kollimationslinse 20'. Die Kollimationslinse 20' weist die Eintrittsseite E20 und die Austrittsseite A20 auf. Eine Fläche 21' zur Kollimation des Strahlungsfeldes in der zweiten Ebene ist integral mit dem zweiten zusätzlichen optischen Element 30 gefertigt. Die Fläche 21' ist ähnlich wie die Fläche 21 aus Figur 2a im Grundsatz zylindrisch ausgebildet. Jedoch ist diese zylindrische Ausbildung überlagert mit einer Freiformfläche, welche das zusätzliche optische Element 30 bildet. Vorliegend ist der Bereich der kombinierten Flächen 30, 21' zusätzlich zur Zylindrizität quer dazu leicht konkav ausgebildet.

Die Freiformfläche ist nach der Formel

$$h_{(x,y)} = a_{20}\,x^2 + a_{40}\,x^4 + a_{22}\,x^2 y^2 + + a_{60}\,x^6 + a_{42}\,x^4 y^2 + a_{24}\,x^2 y^4$$

gestaltet. Dies ermöglicht die Kollimation des Strahlungsfeldes in der Slow Axis Ebene und zusätzlich die Kollimation des Lichtes, welches sich weder in der Slow Axis Ebene noch in der Fast Axis Ebene ausbreitet.

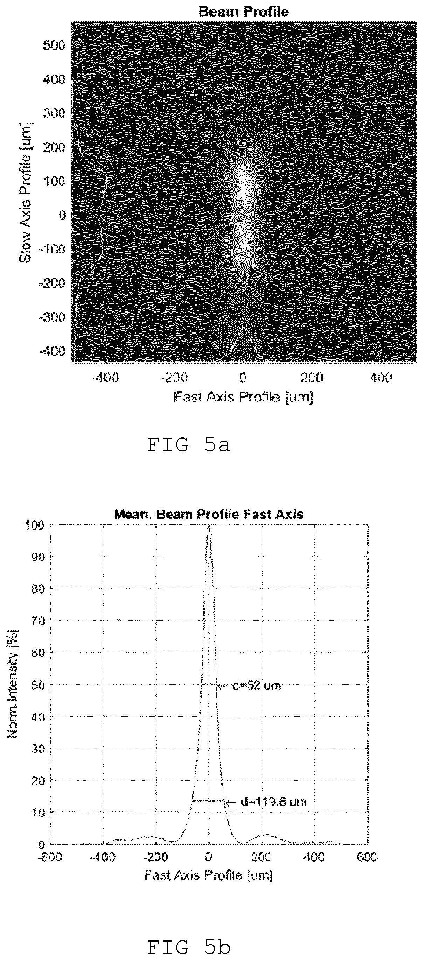

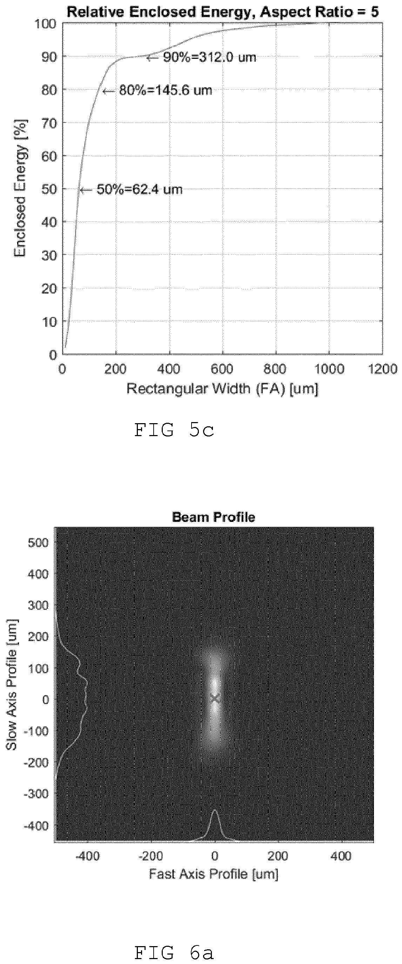

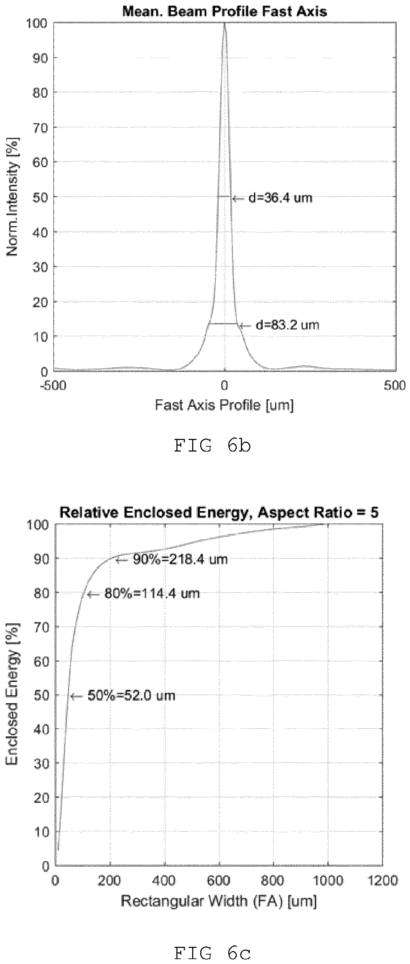

Die Figur 4 zeigt eine Simulation des Strahlungsfeldes nach FAC und SAC in Kombination mit der zusätzlichen Kollimation mit dem Element 30 in der dazu unterschiedlichen Ebene. Im Gegensatz zur Simulation aus der Figur 2 sind hier keine verschwommenen Randbereiche mehr ersichtlich. Die Energie in einem definierten Bereich ist erhöht. Dies zeigt sich auch in den Figuren 5a bis c (Stand der Technik gemäss Figur 1) im Vergleich zu den Figuren 6a bis c (Vorrichtung gemäss Figur 3).

Die Figuren 5a und 6a zeigen jeweils das Profil des Strahlungsfeldes nach der Kollimation und der Fokussierung mit einer Fokussieroptik. Dabei ist in Figur 6a eine geringere Verbreiterung des Strahlprofils durch die nicht optimal kollimierten schiefen Ausbreitungsrichtungen erkennbar, wobei zentral zudem eine höhere Intensität feststellbar ist. Fig. 5b und 6b zeigen das normierte Strahlprofil in Fast Axis Ebene. Der Vergleich zeigt die Verbesserung im Strahlquerschnitt und die reduzierten Nebenmaxima. Fig. 5 c und 6 c zeigen die eingeschlossene Energie in einem definierten Bereich. Der Vergleich zeigt eine wesentlich verbesserte Effizienz der vorgeschlagenen Lösung. Beispielsweise werden mit der erfindungsgemässen Lösung mit dem verwendeten Aufbau von FAC und SAC oder SAC mit erfindungsgemässer Optimierung und Fokussieroptik 90 % der Energie in einen im Vergleich zum Stand der Technik um den Faktor 2 kleineren Bereich fokussiert.

## Patentansprüche

1. Vorrichtung (100) zur Kollimation eines Strahlungsfeldes (L) mit einer Strahlcharakteristik, die in einer ersten Ebene (F) unterschiedlich zu einer zweiten Ebene (S) ist, umfassend wenigstens eine erste Kollimationslinse (10) zur Kollimation des Strahlungsfeldes (L) in der ersten Ebene (F) und eine zweite Kollimationslinse (20) zur Kollimation des Strahlungsfeldes (L) in der zweiten Ebene (S), **dadurch gekennzeichnet, dass** die Vorrichtung ein zusätzliches optisches Element (30) aufweist, um das Strahlungsfeld (L) in zumindest einer zur ersten Ebene (F) und zur zweiten Ebene (S) unterschiedlichen Ebene zu kollimieren.

2. Vorrichtung (100) nach Anspruch 1, **dadurch gekennzeichnet, dass** das optische Element (30) durch eine dritte Kollimationslinse gebildet ist.

3. Vorrichtung (100) nach Anspruch 2, **dadurch gekennzeichnet, dass** die dritte Kollimationslinse in Strahlrichtung (R) nach der ersten Kollimationslinse (10) und der zweiten Kollimationslinse (20) angeordnet ist.

4. Vorrichtung (100) nach Anspruch 2, **dadurch gekennzeichnet, dass** die dritte Kollimationslinse in Strahlrichtung (R) zwischen der ersten Kollimationslinse (10) und der zweiten Kollimationslinse (20) angeordnet ist.

5. Vorrichtung (100) nach Anspruch 1, **dadurch gekennzeichnet, dass** das zusätzliche optische Element (30) durch einen Bereich auf der zweiten Kollimationslinse (20) gebildet ist und vorzugsweise als integraler Bestandteil der zweiten Kollimationslinse (20) ausbildet ist.

6. Vorrichtung (100) nach Anspruch 5, **dadurch gekennzeichnet, dass** der Bereich in Strahlungsrichtung (R) eintrittsseitig auf der zweiten Kollimationslinse (20) angeordnet ist und eine Fläche zur Kollimation des Strahlungsfeldes in der zweiten Ebene (S) auf der zweiten Kollimationslinse (20) in Strahlungsrichtung (R) austrittsseitig angeordnet ist.

7. Vorrichtung (100) nach Anspruch 5, **dadurch gekennzeichnet, dass** der Bereich in Strahlungsrichtung (R) und eine Fläche zur Kollimation des Strahlungsfeldes in der zweiten Ebene (S) auf der zweiten Kollimationslinse (20) in Strahlungsrichtung (R) austrittsseitig angeordnet ist.

8. Vorrichtung (100) nach Anspruch 1, **dadurch gekennzeichnet, dass** das zusätzliche optische Element (30) durch einen Bereich auf der ersten Kollimationslinse (10) gebildet ist und vorzugsweise als integraler Bestandteil der ersten Kollimationslinse (10) ausbildet ist.

9. Vorrichtung (100) nach Anspruch 8, **dadurch gekennzeichnet, dass** der Bereich in Strahlungsrichtung (R) eintrittsseitig auf der ersten Kollimationslinse (10) angeordnet ist und eine Fläche zur Kollimation des Strahlungsfeldes in der ersten Ebene (F) auf der ersten Kollimationslinse (10) in Strahlungsrichtung (R) austrittsseitig angeordnet ist.

10. Vorrichtung (100) nach Anspruch 8, **dadurch gekennzeichnet, dass** der Bereich in Strahlungsrichtung (R) und eine Fläche zur Kollimation des Strahlungsfeldes in der ersten Ebene (F) auf der ersten Kollimationslinse (10) in Strahlungsrichtung (R) austrittsseitig angeordnet ist.

11. Vorrichtung (100) nach einem der Ansprüche 1 bis 10, **dadurch gekennzeichnet, dass** das zusätzliche optische Element (30) als Freiformfläche ausgebildet ist, wobei deren Oberfläche zumindest zwei unterschiedliche Krümmungen in zwei unterschiedlichen Ebenen aufweist und wobei zumindest eine der Krümmungen keinen konstanten Krümmungsradius aufweist.

12. Vorrichtung (100) nach einem der Ansprüche 1 bis 11, **dadurch gekennzeichnet, dass** das zusätzliche optische Element eine Oberflächentopographie mit der Form

$$h_{(x,y)} = a_{20}\, x^2 + a_{40}\, x^4 + a_{22}\, x^2 y^2 + + a_{60}\, x^6 + a_{42}\, x^4 y^2 + a_{24}\, x^2 y^4$$

aufweist, wobei h die Höhe der Oberfläche in Ausbreitungsrichtung angibt und wobei x und y die orthogonalen Koordinatenachsen in der Ebene senkrecht zur Strahlungsrichtung (R) sind.

13. Vorrichtung (100) nach einem der Ansprüche 1 bis 12,
**dadurch gekennzeichnet, dass** die erste Kollimationslinse (10) und die zweite Kollimationslinse (20) und das zusätzliche optische Element (30) einstückig ausgebildet sind.

14. Hochleistungsdiodenlaser umfassend zumindest einen Emitter, bevorzugt mehrere Emitter und wenigstens eine Vorrichtung nach einem der Ansprüche 1 bis 13.

15. Hochleistungsdiodenlaser nach Anspruch 14 umfassend ein Array aus mehreren Emittern, die in einer Ursprungsebene entlang der ersten Ebene (F) und/oder entlang der zweiten Ebene (S) nebeneinander angeordnet sind, wobei jedem Emitter ein zusätzliches optisches Element (30) zugeordnet ist.

16. Modul umfassend eine Vorrichtung (100) nach einem der Ansprüche 1 bis 13 oder einen Hochleistungsdiodenlaser nach Anspruch 14 oder 15 und eine Fokussieroptik.

17. Kollimationslinsenarray, insbesondere für einen Hochleistungsdiodenlaser nach Anspruch 14 oder 15 oder ein Modul nach Anspruch 16, umfassend zwei oder mehrere erste Kollimationslinsen (10) zur Kollimation des Strahlungsfeldes (L) in der ersten Ebene (F) und/oder zwei oder mehrere zweite Kollimationslinsen (20) zur Kollimation des Strahlungsfeldes (L) in der zweiten Ebene (S), **dadurch gekennzeichnet, dass** das Kollimationslinsenarray je Kollimationslinse (10,20) ein zusätzliches optisches Element (30) aufweist, um das Strahlungsfeld (L) in einer zur ersten Ebene (F) und zur zweiten Ebene (S) unterschiedlichen Ebene zu kollimieren.

18. Verfahren zum Kollimieren eines Strahlungsfeldes (L) mit einer Strahlcharakteristik, die in einer ersten Ebene (F) unterschiedlich zu einer zweiten Ebene (S) ist, insbesondere mit einer Vorrichtung (100) nach einem der Ansprüche 1 bis 17, umfassend die Schritte

- Kollimation der Anteile des Strahlungsfeldes (L) der ersten Ebene (F),
- Kollimation der Anteile des Strahlungsfeldes (L) der zweiten Ebene (S)
- Kollimation von Anteilen des Strahlungsfeldes, welche zur ersten Ebene (F) und zur zweiten Ebene (S) unterschiedliche Ebenen aufweisen.

19. Verfahren nach Anspruch 18, wobei zumindest zwei Kollimationen kombiniert durchgeführt werden.

20. Verfahren nach Anspruch 18, wobei drei Kollimationen kombiniert durchgeführt werden.

100

R

S

L 10 L1 20 L2

F

FIG 1

E20 21

A20

20

FIG 1a

Detector Image: Radiant Intensity

28.07.2016
Detector 4, NSCG Surface 1:
Size X: -0.150 to 0.150, Y: -0.200 to 0.200 deg, Pixels 100 W X 100 H, Total Hits = 990310
Peak Intensity : 2.2891E+005 Watts/Steradian
Total Power : 9.9031E-001 Watts

fac_sac.zmx
Configuration 1 of 1

FIG 2

FIG 3

E20 — 30 — 21' — A20 — 20'

FIG 3a

341253
307128
273003
238877
204752
170627
136501
102376
68251
34125
0

Detector Image: Radiant Intensity

28.07.2016
Detector 4, NSCG Surface 1:
Size X: -0.150 to 0.150, Y: -0.200 to 0.200 deg, Pixels 100 W X 100 H, Total Hits = 1000000
Peak Intensity : 3.4125E+005 Watts/Steradian
Total Power : 1.0000E+000 Watts

fac_sac_free.zmx
Configuration 1 of 1

FIG 4

**Beam Profile**

FIG 5a

**Mean. Beam Profile Fast Axis**

FIG 5b

FIG 5c

FIG 6a

FIG 6b

FIG 6c

Europäisches
Patentamt

European
Patent Office

Office européen
des brevets

# EUROPÄISCHER RECHERCHENBERICHT

**Nummer der Anmeldung**

EP 17 15 3942

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | MITSUO NOHARA ET AL: "Aspheric Lens Laser Diode Collimator Design for Optical Intersatellite Communications", JAPANESE JOURNAL OF APPLIED PHYSICS, Bd. 33, Nr. Part 1, No. 3A, 15. März 1994 (1994-03-15), Seiten 1363-1364, XP055378913, JP ISSN: 0021-4922, DOI: 10.1143/JJAP.33.1363 * Seite 1363, Absatz 2 - Absatz 4; Abbildung 1 * ----- | 1-20 | INV. G02B27/09 G02B19/00 |
| X | US 2016/274368 A1 (GUREVICH IGOR [DE]) 22. September 2016 (2016-09-22) * Absatz [0031] - Absatz [0035]; Abbildungen 1,3-4 * ----- | 1-20 | |
| X | US 6 195 208 B1 (NGOI BRYAN KOK ANN [SG] ET AL) 27. Februar 2001 (2001-02-27) * Spalte 2, Zeile 1 - Zeile 9; Abbildung 3 * ----- | 1-20 | |
| A | US 5 790 576 A (WAARTS ROBERT G [US] ET AL) 4. August 1998 (1998-08-04) * Spalte 7, Zeile 66 - Spalte 8, Zeile 2; Abbildung 11 * * Zusammenfassung; Abbildungen 1-4 * ----- | 1-20 | **RECHERCHIERTE SACHGEBIETE (IPC)** G02B |

Der vorliegende Recherchenbericht wurde für alle Patentansprüche erstellt

| Recherchenort | Abschlußdatum der Recherche | Prüfer |
|---|---|---|
| München | 8. Juni 2017 | Kaiser, Peter |

KATEGORIE DER GENANNTEN DOKUMENTE

X : von besonderer Bedeutung allein betrachtet
Y : von besonderer Bedeutung in Verbindung mit einer
   anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
   nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes
   Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 17 15 3942

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

08-06-2017

| Im Recherchenbericht angeführtes Patentdokument | Datum der Veröffentlichung | Mitglied(er) der Patentfamilie | Datum der Veröffentlichung |
|---|---|---|---|
| US 2016274368 A1 | 22-09-2016 | KEINE | |
| US 6195208 B1 | 27-02-2001 | KEINE | |
| US 5790576 A | 04-08-1998 | US 5790576 A<br>US 6222864 B1 | 04-08-1998<br>24-04-2001 |

Für nähere Einzelheiten zu diesem Anhang : siehe Amtsblatt des Europäischen Patentamts, Nr.12/82

EPO FORM P0461